# EUROPEAN PATENT SPECIFICATION

(11) **EP 0 671 848 B1**
(45) Date of publication and mention of the grant of the patent: **21.04.1999**
(21) Application number: 95301580.7
(22) Date of filing: 10.03.1995
(51) Int. Cl.: H04N 5/12

(54) **Automatic digital frequency control circuit**
Digitale Schaltung zur automatischen Frequenzsteuerung
Circuit numérique de commande automatique de fréquence

(30) Priority: 11.03.1994 KR 9404803
(43) Date of publication of application: 13.09.1995
(73) Proprietor: Samsung Electronics Co., Ltd., Suwon-city, Kyungki-do 441-370 (KR)
(72) Inventor: Kim, Ji-ho, Tobong-gu, Seoul (KR)
(74) Representative: Neill, Alastair William

(56) References cited:
- EP-A- 0 071 506
- EP-A- 0 556 643
- US-A- 5 267 040

## Description

### Field of the Invention

The present invention relates to automatic digital frequency control circuits adapted to a digital video signal processing apparatus, and particularly to automatic digital frequency control circuits capable of generating a frequency signal which is synchronized to a horizontal sync signal without oscillating a separate comparison frequency by using a phase locked loop circuit.

### Background to the Invention

A video cassette recorder generally converts a carrier chrominance signal into a low-band frequency and records the converted signal on tape. It requires a low-band carrier frequency of which the phase is synchronized to a horizontal sync signal to convert the carrier chrominance signal into the low-band frequency. The low-band carrier frequency is approximately 40f_{H} (=629KHz) in the case of a VHS (Video Home System) standard, and 45.25f_{H} (=743KHz) in the case of an 8mm system, respectively with respect to a horizontal sync signal frequency f_{H}. Thus, an automatic frequency control circuit should generate exactly a low-band carrier frequency of 47.25 cycles (8mm system) or 40 cycles (VHS standard) every scanning line.

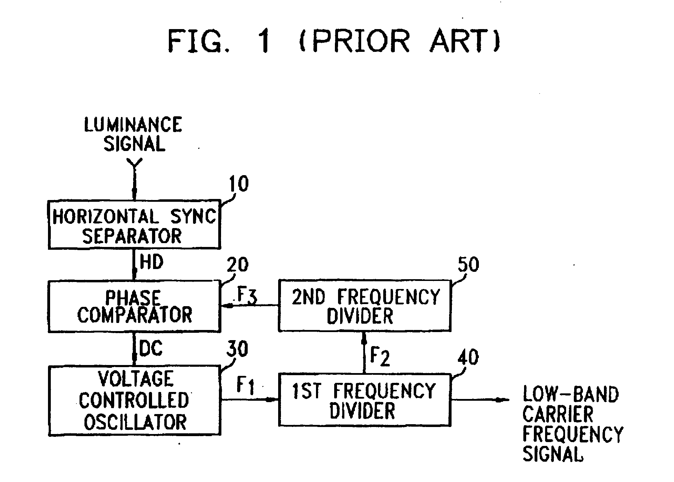

As shown in Figure 1, a circuit for generating a low-band carrier frequency which is synchronized to a horizontal sync signal in an analog video signal processing circuit is comprised of a phase locked loop circuit. In Figure 1, a horizontal sync separator 10 separates a horizontal sync signal HD from an input luminance signal and supplies the separated horizontal sync signal HD to a phase comparator 20. Phase comparator 20 generates a control direct-current (DC) voltage and supplies control DC voltage to a voltage controlled oscillator 30. Voltage controlled oscillator 30 generates a signal F₁ and supplies signal F₁ to a first frequency divider 40. First frequency divider 40 frequency-divides signal F₁ into a quarter times thereof, to generate a signal F₂ and a low-band carrier frequency signal. A second frequency divider 50 receives signal F₂ and frequency-divides received signal F₂ into 1/40 times thereof, to generate a signal F₃. Phase comparator 20 generates the control DC voltage based on a phase comparison result between horizontal sync signal HD and signal F₃.

An operation in the case of a VHS circuit of the Figure 1 apparatus as constructed above will be described below.

When a luminance signal of a colour video signal is input to horizontal sync separator 10, a horizontal sync signal HD is separated from the luminance signal and the separated horizontal sync signal HD is output to phase comparator 20. Phase comparator 20 compares a phase of signal F₃ applied from second frequency divider 50 with that of horizontal sync signal HD and generates the control DC voltage corresponding to a phase difference. The control DC voltage is supplied to voltage controlled oscillator 30 and is used for controlling an oscillated frequency. At an initial operation, voltage controlled oscillator 30 generates signal F₁ have a frequency of 160f_{H}, first frequency divider 40 generates F₂ having a frequency of 40f_{H}, and second frequency divider 50 generates signal F₃ having a frequency of f_{H}. However, if control DC voltage signal is generated according to the phase difference of signal F₃ and horizontal sync signal HD, the frequency of signal F₁ generated by voltage controlled oscillator 30 is varied. Accordingly, the frequencies of signals F₂ and F₃ are also varied. If voltage controlled oscillator 30 generates signal F₁ of which the frequency is varied according to the magnitude of control DC voltage, first frequency divider 40 receives signal F₁ and generates signal F₂ which is synchronized to horizontal sync signal HD. Then, second frequency divider 50 receives signal F₂ and generates signal F₃ which is synchronized to horizontal sync signal HD. Signal F₂ generated in first frequency divider 40 is supplied to a carrier converter (not shown) and is used as a low-band carrier signal of which the phase is synchronized to horizontal sync signal HD.

In the analog circuit as described above, voltage controlled oscillator 30 is used to oscillate a high frequency signal and the oscillated signal is converted into a lower frequency signal again to obtain a desired frequency signal. However, the above-described method cannot be adapted to a digital circuit. That is, although only voltage controlled oscillator 30 can be used, it also is difficult to generate a high frequency signal in the digital circuit. Particularly, a signal processing method for a video cassette recorder has recently been changed from an analog system to a digital system. Therefore, if a low-band carrier frequency generating algorithm (which is used in an existing analog system) is adapted to a digital circuit for recording a chrominance signal as it is, the volume of the circuit becomes excessively large.

EP-A-O 071 506 discloses a circuit for correcting the phase error of a characteristic frequency in the digital domain. The circuit comprises a sampler for generating a digital representation of the frequency, a circuit for producing a phase correction signal, and circuits for applying the phase correction signal to a carrier generator to generate the carrier.

### Summary of the Invention

Therefore, it is an aim of embodiments of the present invention to provide an automatic frequency control circuit capable of digitally performing a signal processing for automatic frequency control.

According to the present invention, there is provided an automatic digital frequency control circuit for generating a carrier which is synchronized to a digital horizontal sync signal, the automatic digital frequency control circuit comprising:
a phase difference calculator for calculating and outputting a phase difference signal between adjacent two scanning lines in response to an error value of a digital horizontal sync signal with respect to a present scanning line and a phase value of a previous scanning line;
a phase difference accumulator for receiving the phase difference signal supplied from the phase difference calculator and accumulating the received phase difference signal to a phase difference accumulated value which has been already stored therein and outputting a newly obtained phase difference accumulated value by the accumulation operation;
an oscillation step corrector for generating fundamental oscillation step data, correcting the fundamental oscillation step data by using correction step data generated according to the phase difference accumulated value supplied from the phase difference accumulator, and generating the corrected oscillation step data;
a phase value generator for receiving the corrected oscillation step data, increasing a phase value which has been already stored therein in unit of the corrected oscillation data, generating a phase value for carrier generation with respect to the present scanning line, and supplying the plurality of the generated phase values to the phase difference calculator; and
a carrier generator for generating a carrier having a frequency corresponding to each phase value generated from the phase value generator.

Suitably, said phase difference calculator comprises:
a first phase corrector for adding the phase value supplied from said phase value generator to a digital horizontal sync signal error value and generating a phase value obtained by correcting a phase error generated when a digital sync signal is obtained by sampling an analog horizontal sync signal;
a first phase storage unit for latching the corrected phase value output from said first phase corrector in response to the digital horizontal sync signal;
a second phase storage unit for receiving the corrected phase value output from said first phase storage unit and latching the corrected phase value preceding one scanning line in response to the digital horizontal sync signal; and
a first operator for receiving the corrected phase values supplied from said first and second phase units and generating the phase difference value.

Suitably, said phase difference calculator further comprises a second phase corrector for adding the phase delay value between the scanning lines to the phase value preceding one scanning line supplied from said phase storage unit, generating the phase value of which the phase difference between the scanning lines is corrected, and outputting the result for said first operator.

Suitably, said second phase corrector adds a phase delay value of 90° to the phase value preceding one scanning line and generates a corrected phase value in the case of an 8mm system.

Suitably, said second phase corrector adds a phase delay value of 0° to the phase value preceding one scanning line and generates a corrected phase value in the case of a VHS system.

Suitably, said phase difference accumulator comprises a second operator for adding the phase difference value supplied from said phase difference calculator to the phase difference accumulation value preceding one line and generating a new phase difference accumulation value; and
a fourth phase storage unit for supplying the phase difference accumulation value preceding one line which is stored therein and storing and outputting the new phase difference accumulation value generated by said second operator.

Suitably, said oscillation step corrector comprises a correction step generator for generating correction step data in response to the phase difference accumulation value from said phase difference accumulator, a fundamental step generator for generating fundamental oscillation step data, and a third operator for adding the outputs of said two step generators and generating corrected oscillation step data which is supplied to said phase value generator.

Suitably, said correction step data is calculated using the following equation:$\text{Correction step data =} {\text{[2}}^{\text{n}} {\text{/(f}}_{\text{S}} {\text{/f}}_{\text{H}} \text{)] X [Phase Error Value] X (Tracing Velocity]}$

in which, n is the number of data supplied to said carrier generator, f_{S} is a sampling frequency, f_{H} is a horizontal sync signal frequency, and the tracing velocity represents a degree of making the phase of the carrier coincide with the horizontal sync signal, respectively, the tracing velocity having a value of zero through one.

Suitably, said fundamental oscillation step data is calculated using the following equation:${\text{Fundamental oscillation step = (2}}^{\text{n}} {\text{x f}}_{\text{car}} {\text{/f}}_{\text{S}} \text{)}$

in which n is the number of data supplied to said carrier generator, f_{car} is a low-band carrier frequency, and f_{S} is a sampling frequency.

Suitably, said phase value generator comprises a fourth operator for increasing the phase value feedback whenever the system clock is applied thereto by said corrected oscillation step data supplied to said oscillation step corrector so as to output the result; and
a fifth phase storage unit for supplying the stored phase value to said fourth operator and latching the phase value output from said fourth operator according to the system clock.

Suitably, said carrier generator comprises a look-up table for receiving the phase value supplied from said phase value generator as address data and generating a carrier having a frequency corresponding to the address data.

### Brief Description of the Drawings

A preferred embodiment of the present invention is described, by way of example only, with reference to the drawings wherein:

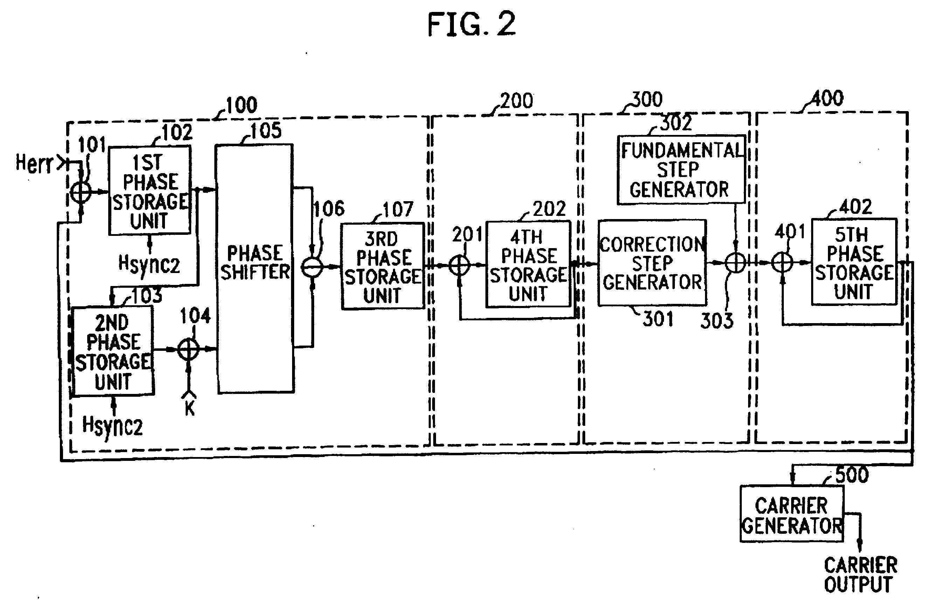

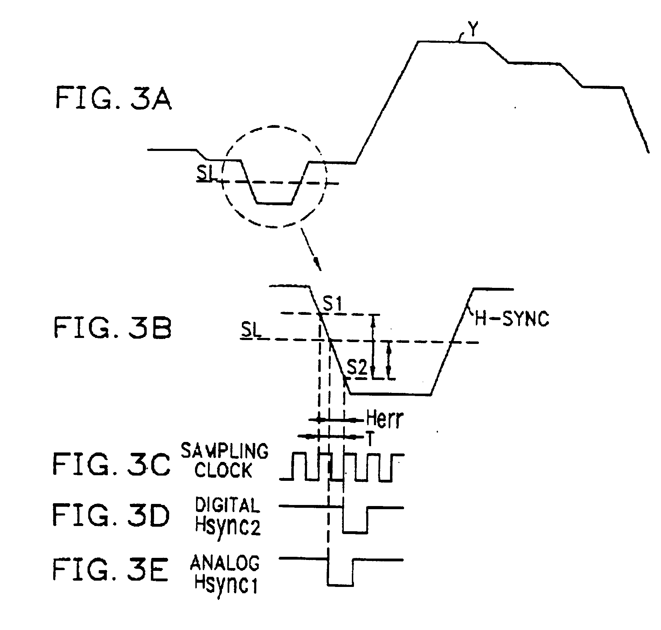

Figure 1 is a block diagram of a conventional automatic frequency control circuit using a phase locked loop circuit. Figure 2 is a block diagram of an automatic digital frequency control circuit according to the present invention. Figures 3A through 3E are signal waveform diagrams for explaining detection of a digital horizontal sync signal and generation of an error thereof.

### Detailed Description of the Preferred Embodiment

A preferred embodiment of the present invention is described below in more detail with reference to the accompanying drawings Figures 2 and 3A through 3E.

A low-band carrier frequency necessary for converting a carrier chrominance signal into a low-band signal should be phase-synchronized to a horizontal sync signal. That is, in the case of an 8mm system which uses a low-band carrier frequency of 47.25f_{H}, the 47.25 low-band carrier frequency signals in numbers should be exactly generated with respect to every scanning line, while in the case of a VHS system which uses a low-band carrier frequency of 40f_{H}, the 40 low-band carrier frequency signals in number should be exactly generated with respect to every scanning line. Therefore, if the difference between phase values of the low-band carrier signals which are detected in the same locations of both one line and the next line is obtained, it is possible to detect a phase error value. If oscillation of the low-band carrier signal is controlled using the detected phase error value, a low-band carrier signal have a frequency close to an ideal value can be generated.

On the other hand, sampling is necessarily required to convert an analog signal into a digital signal which is a discrete signal. During a sampling process by a sampling clock of a predetermined frequency, a value falling between the samples is ignored. This does not matter in general video data, but becomes very significant in sampling a sync signal which is a processing reference signal of the video data. Particularly, since an automatic frequency control circuit for generating a carrier operates sensitively with respect to an error of one clock of a horizontal sync signal, an error value between a point of time at which an actual analog horizontal sync signal is generated and that at which a digital horizontal sync signal is obtained by sampling the analog horizontal sync signal becomes crucial information. Thus, if the automatic frequency control circuit ignores such an error value and adopts only a digital horizontal sync signal as a reference signal for data processing, an error which occurs due to such a reason should be endured. An apparatus considering such an error value of a digital horizontal sync signal is shown in Figure 2.

Figure 2 is a block diagram of an automatic digital frequency control circuit according to one preferred embodiment of the present invention. In Figure 2 a phase difference calculator 100 receives an error value Herr of a digital horizontal sync signal and phase value supplied from a phase value generator 400, and then generates a phase difference value between the two. A phase difference accumulator 200 adds a phase difference accumulated value of a previous line to a current phase difference value and then generates a new phase difference accumulated value. An oscillation step corrector 300 generates correction step data corresponding to a new phase difference accumulated value, and adds the generated new phase difference accumulated value to fundamental oscillation step data, in such a manner that corrected oscillation step data is generated. A phase value generator 400 receives the corrected oscillation step data and generates a new phase value using a stored phase value whenever a system clock is generated. A carrier generator 500 comprises a look-up table and outputs a function value of a sine waveform or a cosine waveform according to a phase value supplied from phase value generator 400, in such a way that carriers having various frequencies are generated.

Prior to describing the operation of the Figure 2 apparatus, a digital horizontal sync signal error value Herr applied to phase difference calculator 100 will be described below with reference to Figures 3A thorough 3E.

Figure 3A shows a luminance signal Y, and Figure 3B shows an enlarged horizontal sync signal H-SYNC among luminance signal Y. If a sampling clock shown in Figure 3C exactly coincides with a separation reference signal SL of the horizontal sync signal, an ideal analog horizontal sync signal HSYNC1 shown in Figure 3E can be obtained. However, since the sampling clock is difficult to exactly coincide with the separation reference value SL, a digital horizontal sync signal HSYNC2 of Figure 3D, which is actually obtained by the sampling, has an approximate error value Herr of ± 0.5 clocks with respect to the analog horizontal sync signal shown in Figure 3B. Assuming that an inclined portion of a horizontal sync signal H-SYNC is linear, such a digital horizontal sync signal error value Herr can be obtained by using the separation reference value SL of the horizontal sync signal and two sample data S1 and S2 located before and after the separation value SL. Since a difference value S1-S2 between the samples corresponds to one period of time T, difference SL-S2 between separation reference value SL and sample data S2 on the horizontal sync signal becomes proportional to digital horizontal sync signal error value Herr. Thus, from an equation of T: S1-S2 = Herr : SL-S2, a value of Herr becomes [(SL-S2)/(S1-S2)] X T.

Returning to Figure 2, when digital horizontal sync signal error value Herr of the current scanning line and the phase value of phase value generator 400 are applied to phase difference calculator 100, first phase corrector 101 adds the two input data to each other, and generates a phase value obtained by correcting a phase error generated when a digital horizontal sync signal is obtained by sampling an analog horizontal sync signal. The output of first phase corrector 101 is supplied to a first phase storage unit 102. First phase storage unit 102 and a second phase storage unit 103 latch the input data thereto, respectively. First phase storage unit 102 and second phase storage unit 103 latch the data input according to digital horizontal sync signal HSYNC2 which has been explained in connection with Figure 3D. Thus, first phase storage unit 102 stores a corrected phase value corresponding to a digital horizontal sync signal HSYNC2 which is currently applied thereto. Second phase storage unit 103 stores a corrected phase value corresponding to a digital horizontal sync signal HSYNC2 from the preceding line which is applied from first phase storage unit 102. Such phase storage units 102 and 103 can be simply designed by using latches. The corrected phase value preceding one line which is output from second phase storage unit 103 is input to a second phase corrector 104. Second phase corrector 104 adds a delayed phase value K to the previous line corrected phase value to remove a phase delay between the lines. In the case of the 8mm system, an ideal low-band carrier has a phase difference of a quarter period of time (90°) every horizontal sync line (1H). Thus, the low-band carrier becomes in-phase every four lines. In the case of the VHS system, the low-band carrier signal has a phase difference of zero between the lines. In the case of the 8mm system, second phase corrector 104 adds a delayed phase value K, that is, 2ⁿ/4 to the input previous line corrected phase value to remove a phase delay of 90° between the lines, and supplies a phase value preceding the one line of which the phase delay between the lines is corrected to a phase shifter 105. Here, n is the number of address bits of a look-up table which will be described later. Phase shifter 105 shifts the difference between the phase value applied from first phase storage unit 102 the phase value output from the second phase corrector 104, so as to easily calculate the difference therebetween. For example, phase shifter 105 shifts the two phase values into the middle for easier comparison, in the case that the two phase values are placed in both the ends of the address. A first operation unit 106 receives the phase values of two lines as processed above, subtracts the received phase values therefrom, and generates a phase difference value of two phase values. The phase difference value is stored and supplied to a third phase storage unit 107.

Phase difference accumulator 200 comprises a second operator 201 which is connected to the output of third phase storage unit 107, and a fourth phase storage unit 202 for storing the output of second operator 201 and supplying the stored data to second operator 201. Second operator 201 adds the phase difference value supplied from third storage unit 107 to the phase difference accumulation value preceding one line which is output from fourth phase storage unit 202, to obtain a new phase difference accumulation value. The newly obtained phase difference accumulation value is stored in fourth phase storage unit 202. That is, fourth phase storage unit 202 stores the input phase difference accumulation value until a new phase difference accumulation value of the next scanning line is supplied thereto.

Oscillation step corrector 300 comprises a correction step generator 301 for receiving the phase difference accumulation value from fourth phase storage unit 202 and generating correction step data, a fundamental step generator 302 for generating fundamental oscillation step data, and a third operator 303 for adding the outputs of two step generators 301 and 302. If the phase difference accumulation value output from fourth phase storage unit 202 is applied to correction step generator 301, correction step data corresponding to the input phase difference accumulation value is generated in correction step generator 301 using the following equation:$\text{Correction step data =} {\text{[2}}^{\text{n}} {\text{/(f}}_{\text{S}} {\text{/f}}_{\text{H}} \text{)] X [Phase Error Value] X [Tracing Velocity]}$

Here, n is the number of addresses of a look-up table, f_{S} is a sampling frequency, f_{H} is a horizontal sync signal frequency, and the tracing velocity represents a degree of making the phase of the carrier coincide with the horizontal sync signal, respectively. The tracing velocity has a value of zero through one. When the tracing velocity is zero, the automatic frequency control circuit is turned off, while when the former is one, the latter has the maximum tracing velocity. The correction step data output from correction step generator 301 is supplied to third operator 303. At this time, the fundamental oscillation step data generated from fundamental step generator 302 is also applied to third operator 303. Fundamental step generator 302 generates the fundamental oscillation step using the following equation:${\text{Fundamental oscillation step = (2}}^{\text{n}} {\text{X f}}_{\text{car}} {\text{/f}}_{\text{S}} \text{)}$

Here f_{car} is a low-band carrier frequency, which is 743KHz in the case of the 8mm system, but which is 629KHz in the case of the VHS system. Third operator 303 adds the correction step data to the fundamental oscillation step data to produce corrected oscillation step data which is supplied to phase value generator 400.

Phase value generator 400 comprises a fourth operator 401 for accumulating the phase value which is applied on the basis of the corrected oscillation step data, and a fifth phase storage unit 402 for storing the phase value output from fourth operator 401 and outputting the stored phase value for fourth operator 401. If the system clock (not shown) is applied to fourth operator 401, the phase value applied from fifth phase storage unit 402 is increased by the corrected oscillation step data, and the increased phase value is supplied to fifth phase storage unit 402. Fifth phase storage unit 402 latches the phase value applied from fourth operator 401. Such an operation is continuously performed whenever the system clock is applied thereto. The phase value latched in fifth phase storage unit 402 is supplied to first phase corrector 101 of phase difference calculator 100. Phase value generator 400 generates a new phase value whenever the system clock is applied thereto. First phase storage unit 102 stores data which is applied from phase value generator 400 only when horizontal sync signal HSYNC2 is applied thereto. Thus, phase storage units 102 and 103 store only one phase value with respect to each scanning line, respectively.

On the other hand, carrier generator 500 receives the phase value output from fifth phase storage unit 402 as address data for an internal look-up table, and then generates a carrier having a frequency corresponding to the input phase value. The look-up table has an address of 0 through 2ⁿ. Here, such an address becomes a phase value (0° through 360°) of one period of time for a sine waveform or a cosine waveform.

As described above, the automatic digital frequency control circuit according to the present invention does not use a voltage controlled oscillator which is a limiting factor when making the digital system, but can generate a carrier which is synchronized to a horizontal sync signal. Thus, the present invention can provide a simple and compact automatic digital frequency control circuit having excellent performance.

While only certain embodiments of the invention have been specifically described herein, it will apparent that numerous modifications may be made thereto without departing from the scope of the invention.

## Claims

1. An automatic digital frequency control circuit for generating a carrier which is synchronized to a digital horizontal sync signal, said automatic digital frequency control circuit comprising:
a phase difference calculator (100) for calculating and outputting a phase difference signal between adjacent two scanning lines in response to an error value (Herr) of a digital horizontal sync signal with respect to a present scanning line and a phase value of a previous scanning line;
a phase difference accumulator (200) for receiving the phase difference signal supplied from said phase difference calculator (100) and accumulating the received phase difference signal to a phase difference accumulated value which has been already stored therein and outputting a newly obtained phase difference accumulated value by the accumulation operation;
an oscillation step corrector (300) for generating fundamental oscillation step data, correcting the fundamental oscillation step data by using correction step data generated according to the phase difference accumulated value supplied from said phase difference accumulator, and generating the corrected oscillation step data;
a phase value generator (400) for receiving the corrected oscillation step data, increasing a phase value which has been already stored therein in unit of the corrected oscillation data, generating a plurality of phase values for carrier generation with respect to the present scanning line and supplying the generated phase values to said phase difference calculator (100); and
a carrier generator (500) for generating a carrier having a frequency corresponding to each phase value generated from said phase value generator (400).

2. An automatic digital frequency control circuit according to Claim 1, wherein said phase difference calculator (100) comprises:
a first phase corrector (101) for adding the phase value supplied from said phase value generator (400) to a digital horizontal sync signal error value and generating a phase value obtained by correcting a phase error generated when a digital sync signal is obtained by sampling an analog horizontal sync signal;
a first phase storage unit (102) for latching the corrected phase value output from said first phase corrector (101) in response to the digital horizontal sync signal;
a second phase storage unit (103) for receiving the corrected phase value output from said first phase storage unit (102) and latching the corrected phase value preceding one scanning line in response to the digital horizontal sync signal; and
a first operator (106) for receiving the corrected phase values supplied from said first (102) and second (103) phase units and generating the phase difference value.

3. An automatic digital frequency control circuit according to Claim 2, wherein said phase difference calculator (100) further comprises a second phase corrector (104) for adding the phase delay value between the scanning lines to the phase value preceding one scanning line supplied from said phase storage unit (102), generating the phase value of which the phase difference between the scanning lines is corrected, and outputting the result for said first operator (106).

4. An automatic digital frequency control circuit according to Claim 3, wherein said second phase corrector (104) adds a phase delay value of 90° to the phase value preceding one scanning line and generates a corrected phase value in the case of an 8mm system.

5. An automatic digital frequency control circuit according to Claim 3, wherein said second phase corrector (104) adds a phase delay value of 0° to the phase value preceding one scanning line and generates a corrected phase value in the case of a VHS system.

6. An automatic digital frequency control circuit according to any preceding claim, wherein said phase difference accumulator comprises a second operator (201) for adding the phase difference value supplied from said phase difference calculator (100) to the phase difference accumulation value preceding one line and generating a new phase difference accumulation value; and
a fourth phase storage unit (202) for supplying the phase difference accumulation value preceding one line which is stored therein and storing and outputting the new phase difference accumulation value generated by said second operator (201).

7. An automatic digital frequency control circuit according to any preceding claim, wherein said oscillation step corrector (300) comprises a correction step generator (301) for generating correction step data in response to the phase difference accumulation value from said phase difference accumulator (200), a fundamental step generator (302) for generating fundamental oscillation step data, and a third operator (303) for adding the outputs of said two step generators (301, 302) and generating corrected oscillation step data which is supplied to said phase value generator (400).

8. An automatic digital frequency control circuit according to any preceding claim, wherein said correction step data is calculated using the following equation:$\text{Correction step data =} {\text{[2}}^{\text{n}} {\text{/(f}}_{\text{S}} {\text{/f}}_{\text{H}} \text{)] X [Phase Error Value] X [Tracing Velocity]}$ in which, n is the number of data supplied to said carrier generator (500), f_{S} is a sampling frequency, f_{H} is a horizontal sync signal frequency, and the tracing velocity represents a degree of making the phase of the carrier coincide with the horizontal sync signal, respectively, the tracing velocity having a value of zero through one.

9. An automatic digital frequency control circuit according to any preceding claim, wherein said fundamental oscillation step data is calculated using the following equation:${\text{Fundamental oscillation step = (2}}^{\text{n}} {\text{x f}}_{\text{car}} {\text{/f}}_{\text{S}} \text{)}$ in which n is the number of data supplied to said carrier generator (500), f_{car} is a low-band carrier frequency, and f_{S} is a sampling frequency.

10. An automatic digital frequency control circuit according to any preceding claim, wherein said phase value generator (400) comprises a fourth operator (401) for increasing the phase value feedback whenever the system clock is applied thereto by said corrected oscillation step data supplied to said oscillation step corrector (300) so as to output the result; and
a fifth phase storage unit (402) for supplying the stored phase value to said fourth operator (401) and latching the phase value output from said fourth operator (401) according to the system clock.

11. An automatic digital frequency control circuit according to any preceding claim, wherein said carrier generator (500) comprises a look-up table for receiving the phase value supplied from said phase value generator (400) as address data and generating a carrier having a frequency corresponding to the address data.

## Patentansprüche

1. Digitale Schaltung zur automatischen Frequenzsteuerung zum Erzeugen eines Trägers, der zu einem digitalen, horizontalen Sync-Signal synchronisiert ist, wobei die digitale Schaltung zur automatischen Frequenzsteuerung aufweist:
einen Phasendifferenz-Kalkulator (100) zum Berechnen und Ausgeben eines Phasendifferenzsignals zwischen benachbarten zwei Abtastzeilen in Abhängigkeit eines Fehlerwerts (Herr) eines digitalen, horizontalen Sync-Signals in Bezug auf eine momentane Abtastzeile und eines Phasenwerts einer vorherigen abtastzeile;
einen Phasendifferenz-Akkumulator (200) zum Aufnehmen des Phasendifferenzsignals, das von dem Phasendifferenz-Kalkulator (100) zugeführt ist, und zum Akkumulieren des empfangenen Phasendifferenzsignals zu einem in der Phasendifferenz akkumulierten Wert, der schon darin gespeichert worden ist, und zum Ausgeben eines neu erhaltenen, in der Phasendifferenz akkumulierten Werts durch einen Akkumulationsvorgang;
eine Oszillations-Schritt-Korrektureinrichtung (300) zum Erzeugen von fundamentalen Oszillations-Schritt-Daten, zum Korrigieren der fundamentalen Oszillations-Schritt-Daten durch Verwendung der Korrektur-Schritt-Daten, die gemäß dem in der Phasendifferenz akkumulierten Wert erzeugt sind, der von dem Phasendifferenz-Akkumulator zugeführt ist, und zum Erzeugen der korrigierten Oszillations-Schritt-Daten;
einen Phasenwert-Generator (400) zum Aufnehmen der korrigierten Oszillations-Schritt-Daten, zum Erhöhen eines Phasenwerts, der bereits darin in einer Einheit der korrigierten Oszillations-Daten gespeichert worden ist, zum Erzeugen einer Vielzahl von Phasenwerten für eine Trägererzeugung in Bezug auf die momentane Abtastzeile und zum Zuführen der erzeugten Phasenwerte zu dem Phasendifferenz-Kalkulator (100); und
einen Träger-Generator (500) zum Erzeugen eines Trägers, der eine Frequenz entsprechend zu jedem Phasenwert besitzt, der von dem Phasenwert-Generator (400) erzeugt ist.

2. Digitale Schaltung zur automatischen Frequenzsteuerung nach Anspruch 1, wobei der Phasendifferenz-Kalkulator (100) aufweist:
eine erste Phasenkorrektureinrichtung (101) zum Addieren des Phasenwerts, der von dem Phasenwert-Generator (400) zugeführt ist, zu einem digitalen, horizontalen Sync-Signal-Fehlerwert und zum Erzeugen eines Phasenwerts, der durch Korrigieren eines Phasenfehlers erhalten ist, der dann erzeugt wird, wenn ein digitales Sync-Signal durch Abtasten eines analogen, horizontalen Sync-Signals erhalten wird;
eine erste Phasen-Speichereinheit (102) zum Verriegeln des korrigierten Phasenwert-Ausgangs von der ersten Phasenkorrektureinrichtung (101) in Abhängigkeit des digitalen, horizontalen Sync-Signals;
eine zweite Phasen-Speichereinheit (103) zum Aufnehmen des korrigierten Phasenwert-Ausgangs von der ersten Phasen-Speichereinheit (102) und zum Verriegeln des korrigierten Phasenwerts, der einer Abtastzeile vorhergeht, in Abhängigkeit des digitalen, horizontalen Sync-Signals; und
einen ersten Operator (106) zum Aufnehmen der korrigierten Phasenwerte, die von der ersten (102) und der zweiten (103) Phaseneinheit zugeführt sind, und zum Erzeugen des Phasendifferenzwerts.

3. Digitale Schaltung zur automatischen Frequenzsteuerung nach Anspruch 2, wobei der Phasendifferenz-Kalkulator (100) weiterhin eine zweite Phasenkorrektureinrichtung (104) zum Addieren des Phasenverzögerungswerts zwischen den Abtastzeilen zu dem Phasenwert, der einer Abtastzeile vorhergeht, die von der Phasen-Speichereinheit (102) zugeführt ist, zum Erzeugen des Phasenwerts, dessen Phasendifferenz zwischen den Abtastzeilen korrigiert ist, und zum Ausgeben des Ergebnisses für den ersten Operator (106) aufweist.

4. Digitale Schaltung zur automatischen Frequenzsteuerung nach Anspruch 3, wobei die zweite Phasenkorrektureinrichtung (104) einen Phasenverzögerungswert von 90° zu dem Phasenwert hinzuaddiert, der einer Abtastzeile vorhergeht, und einen korrigierten Phasenwert in dem Fall eines 8mm Systems erzeugt.

5. Digitale Schaltung zur automatischen Frequenzsteuerung nach Anspruch 3, wobei die zweite Phasenkorrektureinrichtung (104) einen Phasenverzögerungswert von 0° zu dem Phasenwert hinzuaddiert, der einer Abtastzeile vorhergeht, und einen korrigierten Phasenwert in dem Fall eines VHS Systems erzeugt.

6. Digitale Schaltung zur automatischen Frequenzsteuerung nach einem vorhergehenden Anspruch, wobei der Phasendifferenz-Akkumulator einen zweiten Operator (201) zum Addieren des Phasendifferenzwerts, der von dem Phasendifferenz-Kalkulator (100) zugeführt ist, zu dem Phasendifferenz-Akkumulationswert, der einer Zeile vorhergeht, und zum Erzeugen eines neuen Phasendifferenz-Akkumulationswerts; und
eine vierte Phasen-Speichereinheit (202) zum Zuführen des Phasendifferenz-Akkumulationswerts, der einer Zeile vorhergeht, die darin gespeichert ist, und zum Speichern und Ausgeben des neuen Phasendifferenz-Akkumulationswerts, der durch den zweiten Operator (201) erzeugt ist, aufweist.

7. Digitale Schaltung zur automatischen Frequenzsteuerung nach einem vorhergehenden Anspruch, wobei die Oszillations-Schritt-Korrektureinrichtung (300) einen Korrektur-Schritt-Generator (301) zum Erzeugen von Korrektur-Schritt-Daten in Abhängigkeit des Phasendifferenz-Akkumulationswerts von dem Phasendifferenz-Akkumulator (200), einen fundamentalen Schritt-Generator (302) zum Erzeugen fundamentaler Oszillations-Schritt-Daten und einen dritten Operator (303) zum Addieren der Ausgänge der zwei Schritt-Generatoren (301, 302) und zum Erzeugen korrigierter Oszillations-Schritt-Daten, die zu dem Phasenwert-Generator (400) zugeführt werden, aufweist.

8. Digitale Schaltung zur automatischen Frequenzsteuerung nach einem vorhergehenden Anspruch, wobei die Korrektur-Schritt-Daten unter Verwendung der nachfolgenden Gleichung berechnet werden:$\text{Korrektur-Schritt-Daten =} {\text{[2}}^{\text{n}} {\text{/(f}}_{\text{S}} {\text{/f}}_{\text{H}} \text{)] X [Phasen-Fehlerwert] X [Abtastgeschwindigkeit]}$ wobei jeweils n die Zahl von Daten ist, die zu dem Träger-Generator (500) zugeführt sind, f_{S} eine Abtastfrequenz ist, f_{H} eine horizontale Sync-Signal-Frequenz ist, und die Abtastgeschwindigkeit einen Grad darstellt, um die Phase des Trägers mit dem horizontalen Sync-Signal übreinstimmend zu gestalten, wobei die Abtastgeschwindigkeit einen Wert von null bis eins besitzt.

9. Digitale Schaltung zur automatischen Frequenzsteuerung nach einem vorhergehenden Anspruch, wobei die fundamentalen Oszillations-Schritt-Daten unter Verwendung der nachfolgenden Gleichung berechnet werden:${\text{Fundamentaler Oszillations-Schritt = (2}}^{\text{n}} {\text{x f}}_{\text{car}} {\text{/f}}_{\text{S}} \text{)}$ wobei n die Zahl der Daten, die zu dem Träger-Generator (500) zugeführt sind, f_{car} die Tiefband-Trägerfrequenz ist, und f_{S} die Abtastfrequenz ist.

10. Digitale Schaltung zur automatischen Frequenzsteuerung nach einem vorhergehenden Anspruch, wobei der Phasenwert-Generator (400) einen vierten Operator (401) zum Erhöhen der Phasenwert-Rückführung immer dann, wenn der System-Takt dazu durch die korrigierten Oszillations-Schritt-Daten angewandt wird, die zu der Oszillations-Schritt-Korrektureinrichtung (300) zugeführt sind, um so das Ergebnis auszugeben; und
eine fünfte Phasen-Speichereinheit (402) zum Zuführen des gespeicherten Phasenwerts zu dem vierten Operator (401) und zum Verriegeln des Phasenwertausgangs von dem vierten Operator (401) gemäß dem Systemtakt aufweist.

11. Digitale Schaltung zur automatischen Frequenzsteuerung nach einem vorhergehenden Anspruch, wobei der Trägergenerator (500) eine Durchsichtstabelle zum Aufnehmen des Phasenwerts, der von dem Phasenwert-Generator (400) zugeführt ist, als Adress-Daten und zum Erzeugen eines Trägers, der eine Frequenz entsprechend zu den Adress-Daten besitzt, aufweist.

## Revendications

1. Circuit de commande numérique automatique de fréquence pour la production d'une porteuse synchronisée avec un signal numérique de synchronisation de ligne, ce circuit comprenant :
un calculateur de différence de phase (100) pour le calcul et l'émission d'un signal de différence de phase entre deux lignes de balayage voisines en réponse à une valeur d'erreur (Herr) d'un signal numérique de synchronisation de ligne relativement à la ligne actuelle de balayage et une valeur de phase de la ligne de balayage précédente,
un accumulateur de différence de phase (200) pour la réception du signal de différence de phase fourni par le calculateur de différence de phase (100) et l'accumulation du signal de différence de phase reçu à une valeur accumulée de différence de phase qui y a déjà été mémorisée et l'émission d'une valeur accumulée de différence de phase nouvellement obtenue par l'opération d'accumulation,
un correcteur d'échelon d'oscillation (300) pour la production de données d'échelon d'oscillation fondamental, la correction de ces données au moyen de données d'échelon de correction produites d'après la valeur accumulée de différence de phase fournie par l'accumulateur de différence de phase, et la production des données d'échelon d'oscillation corrigé,
un générateur de valeurs de phase (400) pour la réception des données d'échelon d'oscillation corrigé, l'augmentation d'une valeur de phase qui y a déjà été mémorisée en unité des données d'oscillation corrigées, la production d'une série de valeurs de phase pour la production de porteuse relativement à la ligne actuelle de balayage et la fourniture des valeurs de phase produites au calculateur de différence de phase (100), et
un générateur de porteuse (500) pour la production d'une porteuse ayant une fréquence correspondant à chaque valeur de phase produite par le générateur de valeurs de phase (400).

2. Circuit de commande numérique automatique de fréquence selon la revendication 1, dans lequel le calculateur de différence de phase (100) comprend :
un premier correcteur de phase (101) pour l'addition de la valeur de phase fournie par le générateur de valeurs de phase (400) à une valeur d'erreur de signal numérique de synchronisation de ligne et la production d'une valeur de phase obtenue par correction d'une erreur de phase produite lorsqu'un signal numérique de synchronisation est obtenu par échantillonnage d'un signal analogique de synchronisation de ligne,
une première mémoire de phase (102) pour mémoriser la valeur de phase corrigée émise pour le premier correcteur de phase (101) en réponse au signal numérique de synchronisation de ligne,
une deuxième mémoire de phase (103) pour la réception de la valeur de phase corrigée émise par la première mémoire de phase (102) et la mémorisation de la valeur de phase corrigée précédant une ligne de balayage en réponse au signal numérique de synchronisation de ligne, et
un premier opérateur (106) pour la réception des valeurs de phase corrigées fournies par la première mémoire de phase (102) et la deuxième mémoire de phase (103) et la production de la valeur de différence de phase.

3. Circuit de commande numérique automatique de fréquence selon la revendication 2, dans lequel le calculateur de différence de phase (100) comprend en outre un deuxième correcteur de phase (104) pour l'addition de la valeur de retard de phase entre les lignes de balayage à la valeur de phase précédant une ligne de balayage fournie par la mémoire de phase (102), la production de la valeur de phase dont la différence de phase entre les lignes de balayage est corrigée, et l'émission du résultat pour le premier opérateur (106).

4. Circuit de commande numérique automatique de fréquence selon la revendication 3, dans lequel le deuxième correcteur de phase (104), dans le cas d'un système 8 mm, ajoute une valeur de retard de phase de 90° à la valeur de phase précédant une ligne de balayage et produit une valeur de phase corrigée.

5. Circuit de commande numérique automatique de fréquence selon la revendication 3, dans lequel le deuxième correcteur de phase (104), dans le cas d'un système VHS, ajoute une valeur de retard de phase de 0° à la valeur de phase précédant une ligne de balayage et produit une valeur de phase corrigée.

6. Circuit de commande numérique automatique de fréquence selon l'une des revendications précédentes, dans lequel l'accumulateur de différence de phase comprend un deuxième opérateur (201) pour l'addition de la valeur de différence de phase fournie par le calculateur de différence de phase (100) à la valeur d'accumulation de différence de phase précédant une ligne et la production d'une nouvelle valeur d'accumulation de différence de phase, et
une quatrième mémoire de phase (202) pour la fourniture de la valeur d'accumulation de différence de phase précédant une ligne qui y est mémorisée et la mémorisation et l'émission de la nouvelle valeur d'accumulation de différence de phase produite par le deuxième opérateur (201).

7. Circuit de commande numérique automatique de fréquence selon l'une des revendications précédentes, dans lequel le correcteur d'échelon d'oscillation (300) comprend un générateur d'échelons de correction (301) pour la production de données d'échelon de correction en réponse à la valeur d'accumulation de différence de phase émise de l'accumulateur de différence de phase (200), un générateur d'échelons fondamentaux (302) pour la production de données d'échelon d'oscillation fondamental, et un troisième opérateur (303) pour l'addition des sorties des deux générateurs d'échelons (301, 302) et la production de données d'échelon d'oscillation corrigé, qui sont envoyées au générateur de valeurs de phase (400).

8. Circuit de commande numérique automatique de fréquence selon l'une des revendications précédentes, dans lequel les données d'échelon de correction sont calculées au moyen de la relation suivante :$\text{données d'échelon de correction =} {\text{(2}}^{\text{n}} {\text{/(f}}_{\text{S}} {\text{/f}}_{\text{H}} \text{)) x valeur d'erreur de phase x vitesse de poursuite,}$ où n est le nombre de données fournies au générateur de porteuse (500), f_{S} la fréquence d'échantillonnage et f_{H} la fréquence du signal de synchronisation de ligne, et la vitesse de poursuite représente le degré de réalisation de la coïncidence de la phase de la porteuse avec le signal de synchronisation de ligne et a une valeur de zéro à un.

9. Circuit de commande numérique automatique de fréquence selon l'une des revendications précédentes, dans lequel les données d'échelon d'oscillation fondamental sont calculées au moyen de la relation suivante :${\text{échelon d'oscillation fondamental = 2}}^{\text{n}} {\text{x f}}_{\text{car}} {\text{/f}}_{\text{S}} \text{,}$ où n est le nombre de données fournies au générateur de porteuse (500), f_{car} la fréquence de porteuse de bande inférieure et f_{S} la fréquence d'échantillonnage.

10. Circuit de commande numérique automatique de fréquence selon l'une des revendications précédentes, dans lequel le générateur de valeurs de phase (400) comprend un quatrième opérateur (401) pour l'augmentation de la valeur de phase réinjectée, chaque fois que l'impulsion d'horloge du système y est appliquée, des données d'échelon d'oscillation corrigé fournies au correcteur d'échelon d'oscillation (300) afin d'émettre le résultat, et
une cinquième mémoire de phase (402) pour la fourniture de la valeur de phase mémorisée au quatrième opérateur (401) et la mémorisation de la valeur de phase émise du quatrième opérateur (401) selon l'horloge du système.

11. Circuit de commande numérique automatique de fréquence selon l'une des revendications précédentes, dans lequel le générateur de porteuse (500) comprend une table à consulter pour la réception de la valeur de phase fournie par le générateur de valeurs de phase (400) comme données d'adresse et la production d'une porteuse ayant une fréquence correspondant aux données d'adresse.
